# EUROPEAN PATENT SPECIFICATION

(11) **EP 0 337 314 B1**
(45) Date of publication and mention of the grant of the patent: **12.01.1994**
(21) Application number: 89106159.0
(22) Date of filing: 07.04.1989
(51) Int. Cl.: G05F 3/22, H03K 19/086

(54) **Master slave buffer circuit**
Master-Slave-Pufferschaltung
Circuit de tampon maître-esclave

(30) Priority: 13.04.1988 US 181014
(43) Date of publication of application: 18.10.1989
(73) Proprietor: NATIONAL SEMICONDUCTOR CORPORATION, Santa Clara California 95051-8090 (US)
(72) Inventor: Yee, Loren W., Milpitas, CA. 95035 (US)
(74) Representative: Sparing - Röhl - Henseler Patentanwälte

(56) References cited:
- EP-A- 0 140 744
- EP-A- 0 219 937
- WO-A-83/00397
- US-A- 4 459 540
- US-A- 4 644 249

## Description

The present invention relates to circuits for providing voltage reference levels to the ECL (Emitter-Coupled Logic) circuitry of a semiconductor chip.

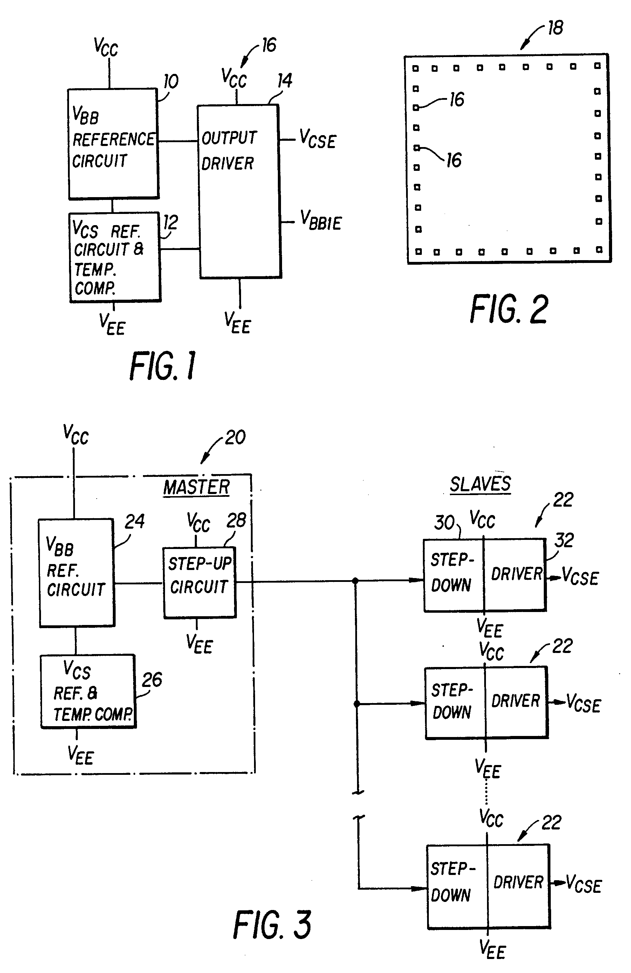

A typical system for providing a reference voltage level is shown in Figure 1. A V_{bb} reference circuit 10 is coupled to a fixed supply voltage, V_{cc}. A temperature compensation and V_{cse} reference circuit 12 is also coupled to this V_{bb} reference circuit. An output driver circuit 14 provides a step down function to the desired voltage level, V_{cse} and V_{bb1e}, as a voltage reference where needed. Elements 10, 12 and 14 form a intermediate voltage reference circuit 16.

Typically, a plurality of voltage reference circuits 16 are arranged around the edges of a semiconductor chip 18 as shown in Figure 2. Each of these circuits 16 reproduces the reference voltage level for supplying reference levels to designated I/O (Input/Output) circuits.

The present invention provides a circuit for providing a voltage reference level using a master circuit and a plurality of slave circuits. The master circuit includes a V_{bb} reference circuit, a temperature compensation and V_{cse} reference circuit, and a voltage step-up and buffering circuit. Each of the slave circuits has a pair of transistors in an emitter-follower configuration to step down the voltage and drive the circuitry requiring the voltage reference.

By using a master circuit and a plurality of slave circuits, the amount of circuitry and power dissipation required to generate each voltage reference level is reduced. This is done by providing the V_{bb} reference circuit, V_{cs} reference circuit and temperature compensation only once in the master circuit, with the output circuit only needing the driver. In addition, the master is provided with a step-up and buffer circuit and the slaves are provided with a step-down circuit as part of the driver. Because the slave uses an emitter-follower configuration to provide the necessary current, the extra transistor voltage drop must be compensated for with the step-up transistor configuration of the master circuit.

The circuit of the present invention is defined by patent claim 1. The features recited in its preamble are known from EP-A-0,140,744. The circuit can either be provided on a chip or externally from the chip, with each chip having a large number of slave circuits arranged around its edges. Thus, the circuitry required on a particular semiconductor chip is much reduced from that of the prior art.

For a fuller understanding of the nature and advantages of the invention, reference should be made to the ensuing detailed description taken in conjunction with the accompanying drawings.

### Brief Description of the Drawings

Figure 1 is a block diagram of a prior art circuit for generating an intermediate voltage reference;
Figure 2 is a diagram of a prior art semiconductor chip with a number of circuits as shown in Figure 1 arranged around its perimeter;
Figure 3 is a block diagram of a master-slave circuit for producing an intermediate voltage reference according to the present invention;
Figure 4 is a diagram of a semiconductor chip showing the arrangement of the master and slave circuits of Figure 3;
Figure 5 is a schematic diagram of an external master-slave circuit according to Figure 3; and
Figure 6 is a schematic diagram of an internal master-slave circuit according to Figure 3 for a master circuit contained on a chip.

### Detailed Description of the Preferred Embodiments

Figure 3 is a block diagram of the present invention showing a master circuit 20 and a plurality of slave circuits 22. The master circuit includes a V_{bb} reference circuit 24, a V_{cs} reference circuit and temperature compensation circuit 26 and a step-up and buffer circuit 28. Each of the slave circuits has a step-down transistor 30 and a driver transistor 32. The step-down transistor also acts as a driver in an emitter-follower configuration with driver 32.

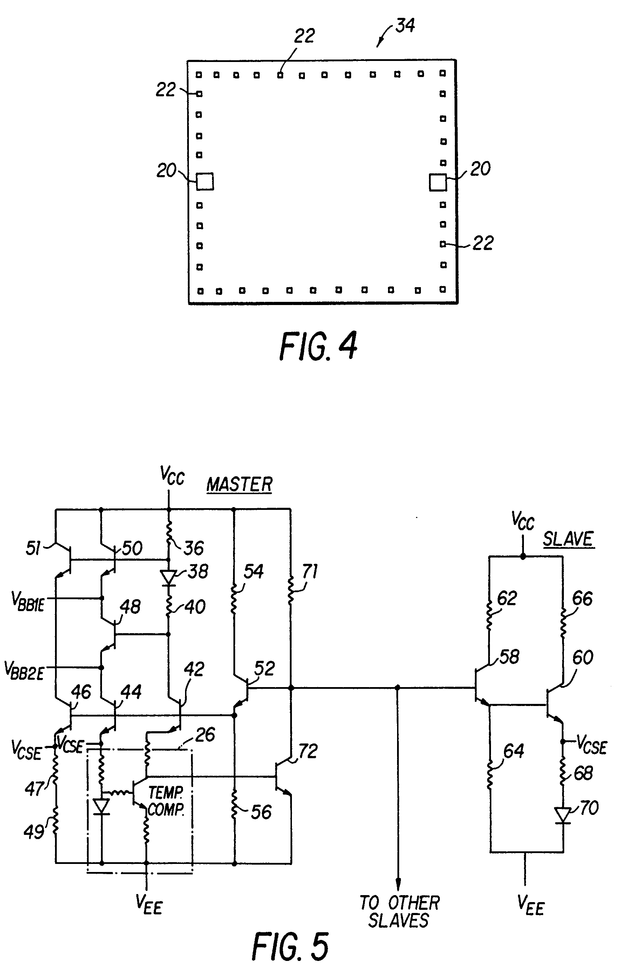

Figure 4 shows the arrangement of the circuit of the present invention on a semiconductor chip 34. A pair of master circuits 20 are shown on two sides of the chip, with a large number of slave circuits 22 arranged around the edges. As can be seen by comparison to Figure 2, the slave circuits take up much less room than the prior art circuit which included all of the elements in one circuit. Typically, one master circuit may be used for 90 slave circuits, with each slave circuit driving 35 logic cells.

Figure 5 shows one embodiment of the present invention in which the master circuit may be located internally to the chip which contains the slave circuits. A V_{bb} reference circuit is provided through resistor 36, diode 38 and resistor 40. The current from this V_{bb} reference circuit is provided to a transistor 42 which has its emitter coupled to a temperature compensation circuit 26. The base of transistor 42 is also coupled to transistors 44 and 46 which provide a V_{cse} voltage reference at their emitters. A pair of transistors 48 and 50 provide level shifting to V_{bb1e} and V_{bb2e}, respectively. The current through resistor 36, diode 38 and resistor 40 essentially sets up the V_{bb1e} and V_{bb2e} levels and is generated from the V_{cs} reference circuit. The present invention shifts up the voltage by one diode level by the addition of a transistor 52. Transistor 52 is coupled to V_{cc} through resistor 54 and to Vₑₑ through a resistor 56, which provides a level shifting function. The base of transistor 52 is coupled to the base of a transistor 58 in each slave circuit.

Each transistor 58 provides a beta drop down to the level of transistor 42 at the base of a output transistor 60. In addition, resistors 62 and 64 are coupled to transistor 58 to provide a match to resistors 54 and 56 of transistor 52 to provide the same current density and cancel temperature effects.

Transistor 52 not only steps up the voltage by one diode level, but also buffers out the temperature and beta effects of transistors 42, 44 and 46. Transistor 58 not only steps the voltage back down, but provides the current needed by output transistor 60, thus reducing the current needed to be produced from the master circuit to the base of transistor 58.

A resistor 66 coupled to output transistor 60 is provided to prevent collector-emitter breakdown. A resistor 68 and a diode 70 are coupled between the emitter of transistor 60 and Vₑₑ.

The base of transistor 52 is coupled to the collector of transistor 72 and level shifts the collector to a voltage two V_{be} (φ) above V_{cse}. Transistors 58 and 60 in each slave circuit shift the voltage down two φ to recreate voltage V_{cse}.

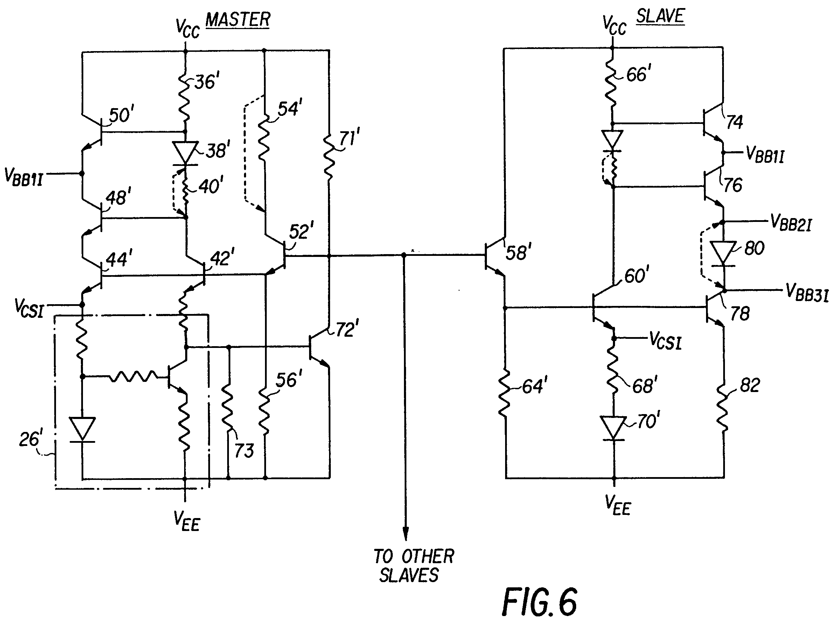

Transistors 51 and 46 and resistors 47 and 49 provide extra drive capability, and could be eliminated where not needed, as shown in Figure 6.

Figure 6 shows an alternate embodiment of the present invention intended for use where the master circuit is on the same semiconductor chip as the slave circuits. The elements shown with a prime symbol (i.e., 54') correspond to the same element in Figure 5 (i.e., 54). The primary difference is the addition of a third leg to the slave circuit having transistors 74, 76 and 78 along with optional diode 80 and resistor 82. This circuit allows the slave circuit to produce two or three higher voltage reference level signals. An extra resistor 73 has been added in the master circuit to adjust the temperature compensation from the 100K bias driver shown in Figure 5 to a 10K bias driver shown in Figure 6.

## Claims

1. A circuit for producing an intermediate reference voltage level between first (V_{CC}) and second (V_{EE}) supply voltages, said circuit having a master circuit (20) including a V_{CS} reference circuit for producing a V_{CS} reference voltage and a plurality of slave circuits (22), each coupled to said master circuit, said intermediate reference voltage level being provided by each of said slave circuits, characterized by:
means (24), coupled to said V_{cs} reference circuit, for producing a first voltage larger than said V_{CS} reference voltage by the base-emitter voltage drop of a transistor in said means for producing (24),
step-up means (28), coupled to said means for producing (24), for producing a second voltage larger than said first voltage by the base-emitter voltage drop of a transistor in said step-up means (28); and
each said slave circuit including first and second slave transistors (58, 60) coupled in an emitter-follower configuration in cascade with the emitter of said first slave transistor (58) coupled to the base of said second slave transistor (60).

2. The circuit of claim 1 wherein said master circuit further comprises a temperature compensation circuit (26) coupled to said V_{cs} reference circuit.

3. The circuit of claim 1 wherein said V_{CS} reference circuit includes a first transistor (42) and said step-up means (28) includes a second transistor (52) having its emitter coupled to a base of said first transistor and a base of said second transistor being coupled to a base of a first one of said emitter-follower slave transistors (58, 60) in each of said slave circuits.

4. The circuit of claim 1 wherein said V_{CS} reference circuit includes a resistor (36) and a diode (38) coupled to said first (V_{CC}) supply voltage.

5. The circuit of claim 1 further characterized by:
said master circuit including
said V_{CS} reference circuit having a resistor (36) and a diode (38) coupled to said first (V_{CC}) supply voltage,
a first transistor (42) having a collector coupled to said V_{CS} reference circuit,
a temperature compensation circuit (26) coupled between an emitter of said first transistor (42) and said second voltage supply (V_{EE})
a second transistor (52) having an emitter coupled to a base of said first transistor (42) and a collector coupled to said first (V_{CC}) supply voltage; and each of said slave circuits including
said first slave transistor (58) having a base coupled to a base of said second transistor (52), an emitter of said second slave transistor (60) being coupled to an output for providing said intermediate voltage level (V_{CSE}), said first and second slave transistors having collectors coupled to said first (V_{CC}) supply voltage; and
a resistor (68) and a diode (70) in series coupling said emitter of said second slave transistor to said second (V_{EE}) supply voltage.

## Patentansprüche

1. Eine Schaltung zum Erzeugen eines Referenzzwischenspannungspegels zwischen einer ersten (V_{CC}) und einer zweiten (V_{EE}) Versorgungsspannung, welche Schaltung einen Mutterschaltkreis (20) umfaßt einschließlich eines V_{CS} Referenzschaltkreises zum Erzeugen einer V_{CS} Referenzspannung und eine Mehrzahl von Tochterschaltkreisen (22), von denen jeder an den Mutterschaltkreis angekoppelt ist, welcher Referenzzwischenspannungspegel von jedem der Tochterschaltkreise bereitgestellt wird, gekennzeichnet durch:
an den V_{CS} Referenzschaltkreis angekoppelte Mittel (24) zum Erzeugen einer ersten Spannung, die größer ist als die V_{CS} Referenzspannung um den Basis-Emitter-Spannungsabfall eines Transistors in den Erzeugungsmitteln (24), an die Erzeugungsmittel (24) angekoppelte Aufstockmittel (28) zum Erzeugen einer zweiten Spannung, die größer ist als die erste Spannung um den Basis-Emitter-Spannungsabfall eines Transistors in den Aufstockmitteln (28), und wobei jeder Tochterschaltkreis erste und zweite Tochtertransistoren (58, 60) umfaßt, die in einer Emitterfolgerkonfiguration in Kaskade gekoppelt sind mit dem Emitter des ersten Tochtertransistors (58), angekoppelt an die Basis des zweiten Tochtertransistors (60).

2. Die Schaltung nach Anspruch 1, bei der der Mutterschaltkreis ferner einen Temperaturkompensationsschaltkreis (26), angekoppelt an den V_{CS} Referenzschaltkreis, umfaßt.

3. Die Schaltung nach Anspruch 1, bei der der V_{CS} Referenzschaltkreis einen ersten Transistor (42) umfaßt und die Aufstockmittel (28) einen zweiten Transistor (52) umfassen mit seinem Emitter an die Basis des ersten Transistors angekoppelt und mit einer Basis des zweiten Transistors angekoppelt an die Basis eines ersten der Emitterfolger-Tochtertransistoren (58, 60) in jedem der Tochterschaltkreise.

4. Die Schaltung nach Anspruch 1, bei der der V_{CS} Referenzschaltkreis einen Widerstand (36) und eine Diode (38) umfaßt, angekoppelt an die erste (V_{CC}) Versorgungsspannung.

5. Die Schaltung nach Anspruch 1, ferner dadurch gekennzeichnet, daß
in dem Mutterschaltkreis der V_{CS} Referenzschaltkreis einen Widerstand (36) und eine Diode (38), angekoppelt an die erste (V_{CC} Versorgungsspannung, umfaßt,
ein erster Transistor (42) mit einem Kollektor an den V_{CC} Referenzschaltkreis angekoppelt ist,
ein Temperaturkompensationsschaltkreis (26) zwischen einen Emitter des ersten Transistors (42) und die zweite Versorgungsspannung (V_{EE}) gekoppelt ist,
ein zweiter Transistor (52) mit einem Emitter an die Basis des ersten Transistors (42) und mit einem Kollektor an die erste (V_{CC}) Versorgungsspannung angekoppelt ist, und daß
bei jedem der Tochterschaltkreise der erste Tochtertransistor (58) mit einer Basis an eine Basis des zweiten Transistors (52) angekoppelt ist, ein Emitter des zweiten Tochtertransistors (60) mit einem Ausgang für die Bereitstellung des Zwischenspannungspegels (V_{CSE}) angekoppelt ist, wobei die Kollektoren des ersten und des zweiten Tochtertransistors an die erste Versorgungsspannung (V_{CC}) angekoppelt sind; und
ein Widerstand (68) und eine Diode (70) in Serie den Emitter des zweiten Tochtertransistors an die zweite Versorgungsspannung (V_{EE}) ankoppeln.

## Revendications

1. Un circuit destiné à produire un niveau de tension de référence intermédiaire entre une première tension d'alimentation (V_{CC}) et une seconde tension d'alimentation (V_{EE}), ledit circuit comprenant un circuit maître (20) comprenant un circuit de référence V_{CS} destiné à engendrer une tension de référence V_{CS} et plusieurs circuits esclaves (22) connectés audit circuit maître, ledit niveau de tension de référence intermédiaire étant fourni par chacun desdits circuits esclaves, ce circuit étant caractérisé en ce qu'il comprend également :
- des moyens générateurs (24) connectés audit circuit de référence V_{CS} pour engendrer une première tension plus grande que ladite tension de référence V_{CS} à l'aide de la chute de tension base-émetteur d'un transistor prévu dans lesdits moyens générateurs (24),
- des moyens élévateurs (28) connectés auxdits moyens générateurs (24) pour engendrer une seconde tension plus grande que ladite première tension à l'aide de la chute de tension base-émetteur d'un transistor dans lesdits moyens élévateurs (28), et
- en ce que chaque circuit esclave comprend des premier et second transistors (58, 60) connectés selon une configuration à émetteur suiveur montée en cascade avec l'émetteur dudit premier transistor esclave (58) connecté à la base dudit second transistor esclave (60).

2. Le circuit selon la revendication 1, dans lequel ledit circuit maître comprend également un circuit de compensation de température (26) connecté audit circuit de référence V_{CS}.

3. Le circuit selon la revendication 1, dans lequel ledit circuit de référence V_{CS} comprend un premier transistor (42) et lesdits moyens élévateurs (28) comprennent un second transistor (52) dont l'émetteur est connecté à une base dudit premier transistor, une base dudit second transistor étant connectée à une base d'un premier desdits transistors esclaves (58, 60) faisant partie de chacun desdits circuits esclaves.

4. Le circuit selon la revendication 1, dans lequel ledit circuit de référence V_{CS} comprend une résistance (36) et une diode (38) connectées à ladite première tension d'alimentation (V_{CC}).

5. Le circuit selon la revendication 1, caractérisé en ce que ledit circuit maître comprend :
- ledit circuit de référence V_{CS} comprenant une résistance (36) et une diode (38) connectées à ladite première' tension d'alimentation (V_{CC}),
- un premier transistor (42) comprenant un collecteur connecté audit circuit de référence V_{CS},
- un circuit de compensation de température (26) connecté entre un émetteur dudit premier transistor (42) et ladite seconde tension d'alimentation (V_{EE}),
- un second transistor (52) dont l'émetteur est connecté à une base dudit premier transistor (42) et dont un collecteur est connecté à ladite première tension d'alimentation (V_{CC}); et chacun desdits circuits esclaves comprenant
- ledit premier transistor esclave (58) comprenant une base connectée à une base dudit second transistor (52), un émetteur dudit second transistor esclave (60) étant connecté à une sortie pour fournir ledit niveau de tension intermédiaire (V_{CSE}), lesdits premier et second transistors esclaves comprenant des collecteurs connectés à ladite première tension d'alimentation (V_{CC}); et
- une résistance (68) et une diode (70) reliées en série et connectant ledit émetteur dudit second transistor esclave à ladite seconde tension d'alimentation (V_{EE}).
